# EUROPEAN PATENT APPLICATION

(11) **EP 4 682 961 A1**
(43) Date of publication of application: **21.01.2026**
(21) Application number: 23934933.5
(22) Date of filing: 20.10.2023
(51) Int. Cl.: H01L 31/18, H01L 31/05, H01L 31/048

(54) **PHOTOVOLTAIC MODULE MANUFACTURING METHOD AND PHOTOVOLTAIC MODULE**

(30) Priority: 25.04.2023 CN 202310456650
(71) Applicant: Ja Solar Technology Yangzhou Co., Ltd., Yangzhou, Jiangsu 225131 (CN)
(72) Inventor: CHEN, Hongyue, Yangzhou, Jiangsu 225131 (CN); SHANG, Lintai, Yangzhou, Jiangsu 225131 (CN); ZHOU, Yanfang, Yangzhou, Jiangsu 225131 (CN)
(74) Representative: Sun, Yiming
(86) International application number: PCT/CN2023/125595
(87) International publication number: WO 2024/221765

(57) **Abstract**

The present disclosure discloses a photovoltaic module manufacturing method and a photovoltaic module. The manufacturing method comprises: step a1, fixing a plurality of cells by means of electrical connecting members to form a battery string structure, wherein the cells comprise a first surface and a second surface which are opposite to each other, and the first surface and the second surface of the cells are each provided with a plurality of fingers and no busbar, step b1, constructing an electrical connection between the cells and the electrical connecting members in the battery string structure to form a battery string; and step c1, performing quality test on the battery string, and manufacturing a photovoltaic module by using a qualified battery string.

## Description

### CROSS-REFERENCE TO RELATED APPLICATIONS

This application claims the priority of the Chinese patent application No. 202310456650.6 filed on April 25, 2023, the disclosure of which is hereby incorporated by reference in its entirety.

### TECHNICAL FIELD

The present invention relates to a photovoltaic module manufacturing method and a photovoltaic module.

### BACKGROUND

For the process of manufacturing photovoltaic modules using heterojunction solar cells, the primary goal is to reduce costs by reducing the metal paste consumption of heterojunction solar cells. One way to reduce the metal paste consumption of heterojunction solar cells is to replace the busbars of the heterojunction solar cells with electrical connecting members (usually low-temperature solder ribbons) that connect the cells in series during the photovoltaic module manufacturing process.

Currently, the process of manufacturing photovoltaic modules using low-temperature solder ribbons to replace the busbars of the heterojunction solar cells primarily involves forming an effective ohmic contact between the low-temperature solder ribbons and the fingers of the heterojunction solar cells by utilizing heat generated during lamination. With the current photovoltaic module manufacturing process, the melting point of the solder ribbons cannot be increased, and the soldering quality of the photovoltaic module can only be tested after encapsulation. Detected defects such as cold solder joints and over-soldering cannot be repaired, resulting in quality risks for photovoltaic modules and a low mass production yield rate for the manufacturing process.

### SUMMARY

In view of this, the present disclosure provides a photovoltaic module manufacturing method and a photovoltaic module. In the process of manufacturing a photovoltaic module using solar cells without a busbar, after the electrical connecting members are laid and prior to the lamination of the encapsulation film, reliable ohmic contact must be formed between the electrical connecting members and the fingers of the solar cells, and the ohmic contact between the electrical connecting members and the fingers is detected to enable repair of defects such as cold solder joints and over-soldering, thereby effectively improving the reliability of the photovoltaic module manufacturing process and the mass production yield rate.

This disclosure provides the following technical solutions:
First, this disclosure provides a photovoltaic module manufacturing method, comprising:
Step a1: fixing a plurality of cells by means of electrical connecting members to form a battery string structure, wherein
the cells comprise a first surface and a second surface which are opposite to each other, and the first surface and the second surface of the cells are each provided with a plurality of fingers and no busbar;
Step b1: constructing an electrical connection between the cells and the electrical connecting members in the battery string structure to form a battery string;
Step c1: performing quality test on the battery string and manufacturing a photovoltaic module by using a qualified battery string, wherein
Step a1 comprises fixing each current cell to the preceding cell already exiting in the battery string structure through the following steps:
   Step a11: fixing a portion of the electrical connecting members to the fingers of the first surface of the current cell; and
   Step a12: fixing another portion of the electrical connecting members to the fingers of the second surface of the preceding cell.

Second, this disclosure provides a photovoltaic module manufacturing method, comprising:
Step a2: connecting a plurality of cells by means of electrical connecting members to form a battery string;
The cells comprise a first surface and a second surface which are opposite to each other, and the first surface and the second surface of the cells are each provided with a plurality of fingers and no busbar;
Step b2: performing quality test on the battery string and manufacturing the photovoltaic module by using a qualified battery string; wherein,
Step a2 comprises connecting each current cell to a preceding cell already existing in the battery string through the following steps:
   Step a21: fixing and simultaneously electrically connecting a portion of the electrical connecting members to the fingers formed on the first surface of the laid current cell, wherein the formation of the fingers on the first surface of the current cell and the electrical connection to the electrical connecting members are completed simultaneously; and
   Step a22: fixing and simultaneously electrically connecting another portion of the electrical connecting members to the fingers formed on the second surface of the preceding cell corresponding to the current cell, wherein the formation of the fingers on the second surface of the preceding cell and the electrical connection to the plurality of electrical connecting members are completed simultaneously.

Third, embodiments of this disclosure provide a photovoltaic module comprising: a battery string arranged side by side, a cover plate, a back plate, and an encapsulation layer, wherein,
the encapsulation layer is used to encapsulate the battery strings arranged side by side between the cover plate and the back plate;
the battery strings comprise a plurality of cells, a plurality of electrical connecting members arranged between each pair of adjacent cells, and a plurality of protective members corresponding to each cell,
wherein the plurality of electrical connecting members arranged between each pair of adjacent cells connect in series the fingers on the first surface of one adjacent cell and the fingers on the second surface of another adjacent cell;
and the plurality of protective members are provided at multiple intersections between the fingers of each cell and the plurality of electrical connecting members.

### BRIEF DESCRIPTION OF THE DRAWINGS

FIG. 1 is a schematic diagram of the main process flow of the first method for manufacturing a photovoltaic module according to embodiments of this disclosure;
FIG. 2 is a schematic diagram of the relative positional relationship between multiple adhesive members and fingers on the current cell according to embodiments of this disclosure;
FIG. 3 is a schematic diagram of the relative positional relationship between fingers on the current cell and the plurality of electrical connecting members according to embodiments of this disclosure;
FIG. 4 is a schematic diagram of the relative positional relationship between the current cell, the preceding cell, and the plurality of electrical connecting members according to embodiments of this disclosure;
FIG. 5 is a schematic diagram of the relative relationship between the formed electrical connecting members and adhesive members according to embodiments of this disclosure;
FIG. 6 is a schematic diagram of the relative relationship between two adjacent cells of the battery string according to embodiments of this disclosure;
FIG. 7 is a schematic diagram of one relative positional relationship between the protective members and the electrical connecting members according to embodiments of this disclosure;
FIG. 8 is a schematic diagram of another relative positional relationship between the protective members and the electrical connecting members according to embodiments of this disclosure;
FIG. 9 is a schematic diagram of the main flow of the second method for manufacturing a photovoltaic module according to embodiments of this disclosure;
FIG. 10 is a schematic diagram of the structure obtained in step S901 according to embodiments of this disclosure;
FIG. 11 is a schematic diagram of the relative positional relationship between two adjacent busbar-free heterojunction cells in the battery string obtained by the second manufacturing method according to embodiments of this disclosure;
FIG.12 is a schematic diagram of the cross-sectional structure of a photovoltaic module obtained by the manufacturing methods according to embodiments related to FIG. 1 or FIG. 9 of this disclosure.

The reference numerals are as follows:
10 - battery string; 11 - cell; 111 - finger; 112 - connecting lines; 11' - current cell; 11" - preceding cell corresponding to the current cell; 12 - electrical connecting members; 13 - protective member; 14 - adhesive member; 20 - cover plate; 30 - back plate; 40 - encapsulation layer

### DETAILED DESCRIPTION

The battery string structure involved in the embodiments of this disclosure refers to a structure in which the relative positional relationship between portions of the plurality of electrical connecting members and multiple cells is consistent with the relative positional relationship between solder ribbons and cells in the existing battery strings (i.e., the front side and back side of the cells overlap with portions of different electrical connecting members, respectively, wherein the front side of one cell and the back side of the other cell in two adjacent cells overlap with different regions of the same electrical connecting member). However, no electrical connection is established between the electrical connecting members and the overlapping cells.

The battery string involved in the embodiments of this disclosure refers to a structure in which the electrical connection is formed between the electrical connecting members and adjacent cells in the above battery string structure.

The current cell involved in the embodiments of this disclosure generally refers to a cell currently in operation and to be connected in series to a battery string structure/ battery string.

The process of manufacturing a photovoltaic module using the qualified battery strings in the embodiments of this disclosure mainly comprise the stacking and lamination stages, which primarily involve encapsulating the qualified battery strings between a cover plate and a back plate using an encapsulation layer.

The front side of a structure involved in the embodiments of this disclosure generally refers to the primary surface of the structure, as part of the photovoltaic module, which faces sunlight during use. Correspondingly, the back side of a structure generally refers to the primary surface of the structure, as part of the photovoltaic module, which faces away from sunlight during use. For example, the back side and the front side of the cell refer to the two oppositely located, relatively large surfaces of the cell that serve as a backlight surface (the surface facing away from sunlight) and a light-receiving surface (the surface facing sunlight), respectively, of the photovoltaic module.

The terms "first" and "second" involved in the embodiments of this disclosure are merely used to distinguish the locations or structures in contact, or the structures with certain differences, for example, the first surface and the second surface, and do not limit the number or order of structures.

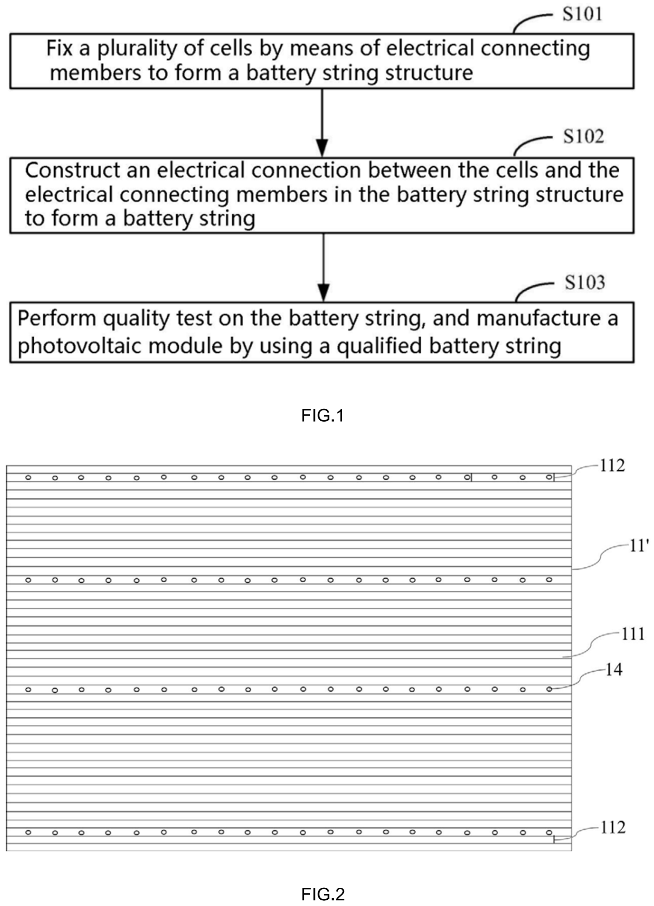

To optimize the current process of manufacturing photovoltaic modules using busbar-free cells and improve the mass production yield rate of photovoltaic modules, the embodiments of this disclosure provide two methods for manufacturing photovoltaic modules. FIG. 1 illustrates a schematic diagram of the main process flow of the first method for manufacturing a photovoltaic module; FIGS. 2-6 illustrate schematic diagrams of the structures obtained by the steps included in the manufacturing method. As shown in FIG. 1, the first method for manufacturing a photovoltaic module may include the following steps:
Step S101: fixing a plurality of cells 11 by means of electrical connecting members 12 to form a battery string structure;
wherein, the cells 11 generally comprise a first surface and a second surface which are opposite to each other, and the first surface and the second surface of the cells 11 are each provided with a plurality of fingers 111 and no busbar;
Step S102: constructing an electrical connection between the cells 11 and the electrical connecting members 12 in the battery string structure to form a battery string 10;
Step S103: performing quality test on the battery string 10, and manufacturing a photovoltaic module by using a qualified battery string 10.

The above step S101 comprises fixing each current cell 11' to a preceding cell 11" already existing in the battery string structure through the following steps S1011 and S1012 (not shown):
Step S1011: fixing a portion of the electrical connecting members 12 to the finger 111 on the first surface of the current cell 11';
Step S1012: fixing another portion of the electrical connecting members 12 to the finger 111 on the second surface of the preceding cell 11".

The current cell 11' generally refers to the cell 11 currently in operation and to be connected in series to the battery string structure. The preceding cell 11" refers to the cell 11 that was connected in series to the battery string structure prior to the current cell 11' relative to the current cell 11', and is adjacent to the current cell 11'.

In the above step S1011, a portion of the electrical connecting members 12 is fixed to the first surface of the current cell 11', such that an assembly is formed by the electrical connecting members 12 and the current cell 11'. This assembly, as a whole, is then used in the subsequent steps to manufacture the battery string structure and battery string 10.

In the embodiments of this disclosure, the electrical connecting member 12 is generally a metal wire or metal mesh made of a conductive metal such as copper, aluminum or other alloy materials, and its cross-section can be rectangular, circular, elliptical, triangular, etc. Furthermore, the surface of the electrical connecting member 12 comprises a protective metal layer, such as tin or other melting point alloy layer.

In addition, in the battery string structure formed in the above step S101 and the battery string formed in the above step S102, a plurality of electrical connecting members 12 are usually provided between each pair of adjacent cells 11 to enhance the electrical conductivity of the photovoltaic module and the connection strength between the cells.

The above electrical connecting members 12 are typically tin-coated copper wires.

The busbar-free cell used in the first manufacturing method according to the embodiments of this disclosure is generally provided with the same number of electrical connecting members 12 on both its front side and back side.

The busbar-free cell generally refers to the absence of a busbar for soldering and corresponding pads or solder joints. The width of the finger 111 on the first and second surfaces of this busbar-free cell is generally 14 µm to 40 µm, effectively reducing the shading of the cell surface by the gridlines. In a preferred embodiment, the above busbar-free cell is a busbar-free heterojunction cell.

Furthermore, the regions of the above finger 111 corresponding to the electrical connecting members 12 can be appropriately thickened to further improve the stability of electrical connection.

It is worth noting that for the other cells in the battery string structure except the first cell as the current cell 11', step S1012 is performed. For the first cell in the battery string structure, only the above step S1011 can be performed.

That is, if the current cell 11' is the first cell of the battery string structure, after completing step S1011 with the first cell as the current cell, steps S1011 and S1012 are performed directly with the second cell as the current cell.

The first cell of the battery string structure generally refers to the first cell laid on the string soldering platform during the process of manufacturing the battery string structure. The first surface and second surface are front side and back side of the cell 11, respectively. Alternatively, the first surface can be the front side and the second surface can be the back side, or the first surface can be the back side and the second surface can be the front side.

Compared to the existing methods for manufacturing photovoltaic modules from busbar free cells, which only achieves series connection between busbar-free cells within the battery string during the lamination stage, the first manufacturing method for the above photovoltaic module provided by the embodiments of this disclosure forms a reliable ohmic contact between the electrical connecting members and the busbar-free cells before lamination. In this way, a quality test is performed directly on the battery strings to select qualified ones for manufacturing photovoltaic modules, and the battery strings are repaired before lamination, thereby effectively improving the reliability and mass production yield rate of photovoltaic modules.

Furthermore, compared to the existing methods for manufacturing photovoltaic modules from busbar-free cells, which achieves series connection between busbar-free cells within the battery string by means of lamination temperature during the lamination stage, the first manufacturing method for the photovoltaic module provided by the embodiments of this disclosure completes the series connection between the respective busbar-free cells in the battery string before lamination, so that the way for achieving the series connection will not be limited by lamination temperature and other conditions. Consequently, the electrical connecting members for connecting the busbar-free cells in series can be made of materials with relatively high temperatures (e.g., materials with temperatures higher than the lamination temperature). That is to say, the solution provided by the embodiments of this disclosure uses the electrical connecting members with melting points higher than the lamination temperature, such that the photovoltaic module has high-temperature resistance and reliability, and can adapt to high-temperature environments.

In addition, compared to the existing process of manufacturing photovoltaic modules with busbar-free cells by using a carrier film to fix the solder ribbons in series in the busbar-free cells, the solution provided by the embodiment of this disclosure can achieve the purpose of fixing the electrical connecting members through the combined action of the electrical connection between the cells and the electrical connecting members and the protective member, without the need to set the carrier film to cover the electrical connecting members, which can avoid the shading of light by the carrier film, thereby improving the photoelectric conversion performance of the battery string and the manufactured photovoltaic module, and at the same time can further reduce the use of conductive paste and reduce the production cost of photovoltaic modules.

Furthermore, in step S102, after the electrical connection is formed between the cells 11 and the electrical connecting members 12, the process may further comprise: providing a protective member 13 at the intersection of the fingers of cells 11 and the electrical connecting members 12. The intersection of the fingers 111 and the electrical connecting members 12 generally refer to the contact points or contact regions where the fingers 111 contact with the electrical connecting members 12.

In the process of manufacturing a battery string using busbar-free cells, protective members are provided at the intersections of the fingers of each cell and the plurality of electrical connecting members to protect electrical connection points between the cells and the plurality of electrical connecting members fixed by the cells. This prevents the lamination pressure applied during the subsequent lamination process of manufacturing the photovoltaic module from damaging the electrical connection points. Even when busbar-free cells are used to manufacture the battery string, a stable and reliable series connection can be constructed between the busbar-free cells in the battery string before lamination. In this way, a quality test can be performed directly on the battery string and the qualified battery strings are selected for manufacturing the photovoltaic modules. Furthermore, the battery strings can be repaired before lamination, thereby effectively improving the reliability and mass production yield rate of photovoltaic modules.

It is worth noting that the above embodiment shown in FIG.1 can also be replaced by: after step S1011, directly constructing the electrical connection between the cells 11 and the plurality of electrical connecting members 12 to which it is fixed; then providing protective members 13 at multiple intersections of the finger 111 of the cells 11 and the plurality of electrical connecting members 12, and connecting the cells 11 provided with the protective members 13 in series, and then soldering and setting the protective members 13 on the cells 11 connected in series again. Compared to the above embodiment shown in FIG.1, the solution provided by this embodiment enables the front side and the back side of the cell 11 to form electrical connection with the electrical connecting members 12 in two stages, and the process complexity is higher. Therefore, compared with this embodiment, the embodiment shown in FIG.1 is a preferred embodiment of the embodiment of this disclosure.

Furthermore, adhesive members 14 are provided on the first surface of the current cell 11' and the second surface of the preceding cell 11' involved in the above steps S1011 and S1012. Adhesive members 14 are located between adjacent fingers. Electrical connecting members 12 are fixed to the fingers on the first surface of the current cell 11' and the fingers on the second surface of the preceding cell 11" by being bonded to the adhesive members 14. As can be understood, since the current cell 11' becomes the preceding cell 11" corresponding to the next current cell 11' after being fixed to the battery string structure, the adhesive members 14 are provided on both the first surface and the second surface of each current cell 11'. The setting of adhesive members 14 can further stabilize the electrical connecting members 12.

Additionally, the number of the above adhesive members 14 provided for each electrical connecting member 12 may be multiple to further stabilize the electrical connecting members 12.

Specifically, the above step S101, prior to step S1011, further comprises: for each cell 11 used for obtaining the battery string structure, performing the following operations: in the case where the cell 11 is used as the current cell 11', setting a plurality of adhesive members 14 on the first surface and the second surface of the current cell 11' respectively, wherein, as shown in FIG. 2, the relative positional relationship between the plurality of adhesive members 14 and the fingers 111 on the current cell 11' is that the plurality of adhesive members 14 are located between adjacent fingers. A plurality of adhesive members 14 are provided between two adjacent fingers 111. If the plurality of adhesive members 14 located between the same two fingers 111 are regarded as a row of adhesive members 14, then at least two rows of adhesive members 14 are respectively provided on the first surface and the second surface of the current cell 11', wherein at least two rows of adhesive members 14 are evenly distributed on the first surface or the second surface to ensure the stability of the electrical connecting members 12.

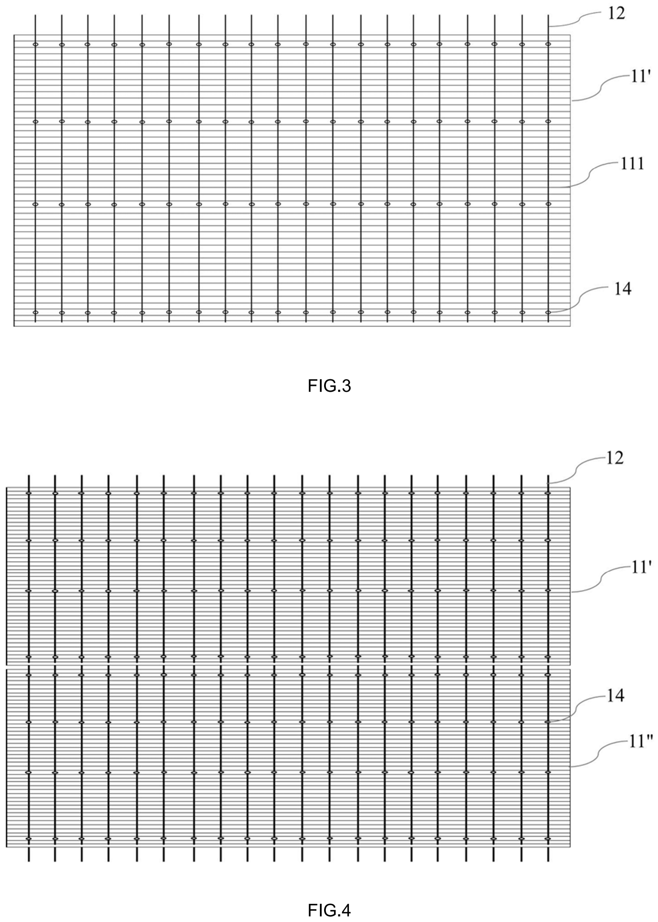

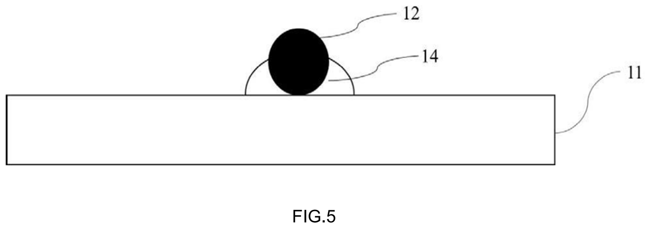

On the basis of providing the plurality of adhesive members 14 between the above two adjacent fingers 111, the specific implementation of the above step S1011 may include: bonding a portion of the multiple electrical connecting members 12 to the plurality of adhesive members 14 disposed on the first surface of the current cell 11', thereby obtaining the relative positional relationship between the fingers 111 on the current cell 11' and the multiple electrical connecting members 12 as shown in FIG. 3. Furthermore, based on the arrangement of the plurality of adhesive members 14, the specific implementation of the above step S1012 may include: bonding another portion of the multiple electrical connecting members 12 to the plurality of adhesive members 14 that are disposed on the second surface of the preceding cell 11' corresponding to the current cell 11', thereby obtaining the relative positional relationship between the current cell 11', the preceding cell 11', and the multiple electrical connecting members 12, as shown in FIG. 4. The relative relationship between the electrical connecting members 12 and the adhesive members 14 is shown in FIG. 5, i.e., the electrical connecting members 12 are embedded in the adhesive members 14, thereby effectively fixing the electrical connecting members 12.

The specific implementation of providing the plurality of adhesive members 14 respectively on the first and second surfaces of the current cell 11' may include: printing adhesive dots as the adhesive members 14 on the first and second surfaces of the current cell 11'. Obtaining the adhesive dots as the adhesive members 14 by printing ensures the consistency of the adhesive members 14, controls the thickness of the adhesive members 14, avoids affecting the connection between the electrical connecting members 12 and the fingers 111, and effectively improves the efficiency of disposing the adhesive members 14.

Specifically, the specific implementation of the above step S102 may include constructing the electrical connection between the cells 11 and a plurality of the electrical connecting members 12 fixed thereto in the battery string by soldering. This soldering method generally involves heating the battery string structure at approximately 200 °C using a heating plate, fusing the plurality of electrical connecting members 12 to the intersections of the fingers of the cells 11, thereby forming an electrical connection. By this process, the fingers of each cell 11 can form the electrical connection simultaneously. Specifically, the process of connecting each battery string (i.e., connecting the electrical connecting member 12 fixed to the current cell to the finger on the front side of the adjacent preceding cell) is synchronized with the process of forming the electrical connection of the fingers on the back side of each cell 11 to the electrical connecting members 12, which omits the process of individually welding the electrical connecting member 12 to the fingers on the back side of each cell 11. This effectively improves the efficiency for manufacturing the battery string and can ensure that the electrical connecting members 12 are not displaced during the process of manufacturing the battery string by setting the adhesive members 14.

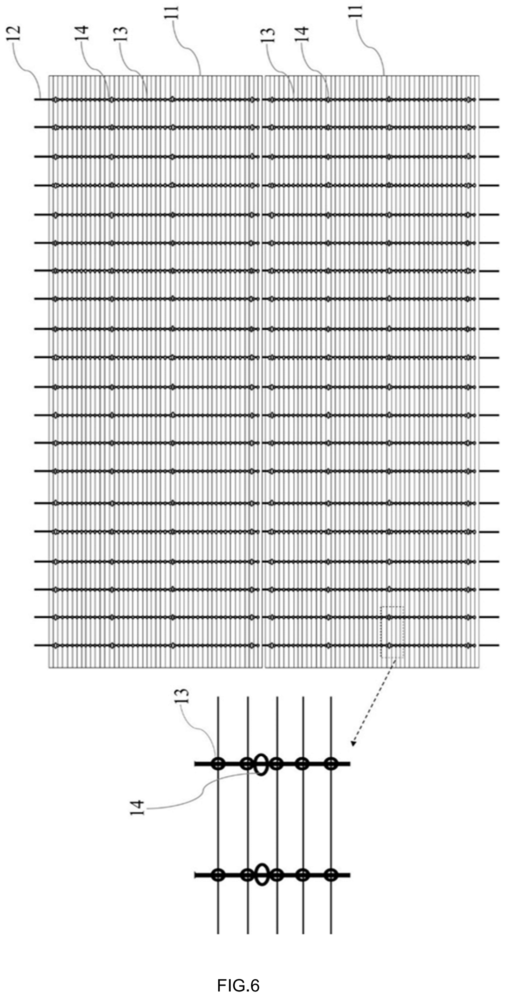

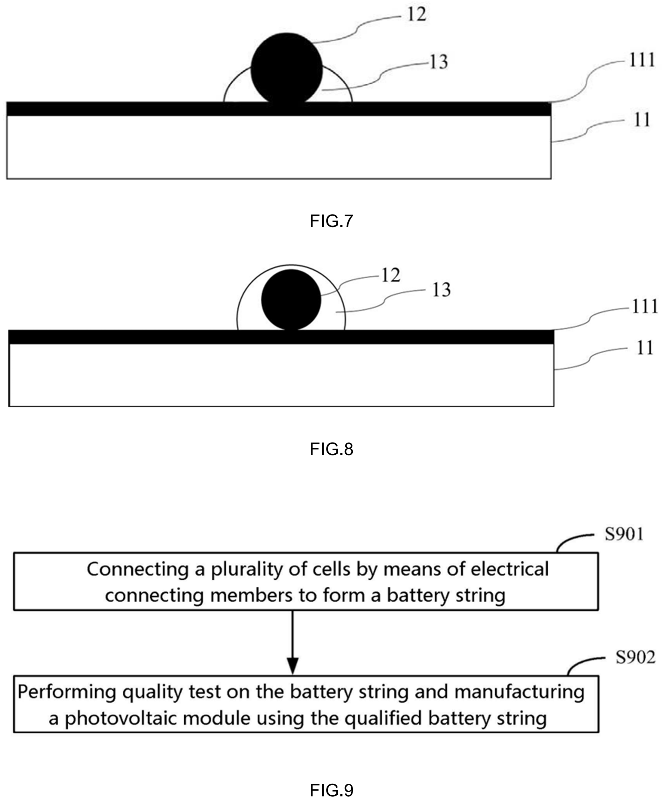

Furthermore, the specific implementation of the step of providing the protective member 13 at the intersection of the fingers 111 of the cells 11 and the electrical connecting members 12 involved in the above embodiment may include: spraying or coating an adhesive at multiple intersections of the fingers of each cell 11 and multiple electrical connecting members 12, wherein the protective member 13 formed by adhesive dispensing at least partially encapsulates a region on the intersection of the electrical connecting members 12, thereby obtaining the relative relationship structure between two adjacent cells of the battery string as shown in FIG. 6. The relative positional relationship between the formed protective member 13 and the electrical connecting member 12 can be shown in FIGs. 7 and 8.

The relative positional relationship between the protective member 13 and the electrical connecting member 12, as shown in FIG. 7, is generally obtained by spraying the adhesive on both sides of the electrical connecting member 12 respectively in contact with the protective member 13. The height of the protective member 13 obtained in this manner is generally smaller than that of the electrical connecting member 12.

The relative positional relationship between the protective member 13 and the electrical connecting member 12, as shown in FIG. 8, is generally achieved by spraying or coating the adhesive on top of the electrical connecting member 12. The adhesive forms the cross-sectional structure of the protective member 13 shown in FIG. 8 by means of its fluidity. The height of the protective member 13 obtained in this manner is generally greater than that of the electrical connecting member 12.

The relative positional relationship between the above two protective members 13 and the electrical connecting member 12 can ensure that the cross-contact position between the electrical connecting member 12 and the finger 111 is protected to avoid damage to the solder joints between the electrical connecting member 12 and the finger 111 so as to ensure that the battery string maintains good electrical conductivity after being laminated.

It is worth noting that the adhesive used to form the protective member 13 can be the same as or different from the adhesive used to form the above adhesive member 14.

The adhesives used to form the protective member 13 and the adhesive used to form the adhesive member 14 exhibit excellent adhesion to the cell surface or fingers. After curing, the adhesive used to form the protective member 13 and the adhesive used to form the adhesive member 14 exhibit a single-point adhesion force of ≥0.3N during the subsequent heating and lamination process for manufacturing the photovoltaic module, thereby achieving the purpose of stabilizing and protecting the electrical connecting members. In addition, the adhesive used to form the protective member 13 and the adhesive used to form the adhesive member 14 are cured and their fluidity when heated is lower than the fluidity of the material selected for the encapsulation layer of the photovoltaic module. During the lamination process, the adhesive forming the adhesive member 14 and the adhesive forming the protective member 13 will not be displaced, and at the same time, the material of the encapsulation layer can be prevented from entering between the finger 111 and the electrical connecting member 12, thereby ensuring the electrical connection performance between the cell 11 and the electrical connecting member 12.

In addition, the melting point of the electrical connecting members 12 used in each embodiment of the first method for manufacturing the photovoltaic module described above is generally not less than 140 °C. In a preferred embodiment, the melting point of the electrical connecting members 12 selected for each embodiment of the first method for manufacturing the photovoltaic module is generally not less than 160 °C. For example, the melting point of the selected electrical connecting members 12 is 160 °C, 170 °C, 180 °C, 190 °C, 200 °C, etc., so that the electrical connecting members 12 and the finger 111 of the cell 11 can be electrically connected through a relatively reliable soldering method (relatively reliable soldering methods generally have relatively high soldering temperatures), while also preventing damage to the electrical connecting members 12 caused by lamination temperature, thereby ensuring stable conductivity of the battery string. It is worth noting that for the first method for manufacturing the photovoltaic module described above, electrical connecting members 12 with an appropriate melting point can be selected based on the layout design.

The temperature resistance of the protective member 13 selected in each embodiment of the first method for manufacturing the photovoltaic module is generally not less than 160 °C. For example, the temperature resistance of the protective member 13 is 170 °C, 180 °C, 190 °C, 200 °C, 220 °C, etc. By selecting a protective member 13 with a temperature resistance of not less than 160 °C, the protective effect can still be achieved during the lamination stage of the photovoltaic module, avoiding the problem of the solder points of the electrical connecting members 12 (i.e., the intersection between the electrical connecting member 12 and the finger 111) being broken due to the lamination pressure. It is worth noting that the temperature resistance of the protective member 13 needs to vary according to the actual melting point of the electrical connecting member 12. As the melting point increases, the temperature resistance increases. Generally, the temperature resistance of the protective member 13 is 20 °C higher than the melting point of the electrical connecting member 12, so that the protective member 13 can achieve better protection effects on the electrical connecting member 12.

In summary, the above first manufacturing method mainly comprises: printing adhesive dots on the front side and the back side of the busbar-free cell (preferably a busbar-free heterojunction cell), placing the electrical connecting member on the adhesive dots on the front side or the back side of the busbar-free cell for thermal curing, placing the electrical connecting members of the cell with electrical connecting members on the adhesive dots on the back side or the front side of the preceding cell, and thermally curing them into a battery string structure; soldering the finger of the cell in the battery string structure to the electrical connecting members, so that the electrical connecting members are alloyed with the fingers on the front side and the back side of the cell to form an effective ohmic connection (i.e., electrical connection); finally, performing adhesive dispensing at each intersection of the fingers and the electrical connecting members, and the adhesive dispensing is thermally cured to strengthen the connection between the metal connecting members and the metal grid lines. After soldering is completed, corresponding efficiency-enhancing measures such as electrical injection, optical injection, etc. can be added according to characteristics of the battery to improve the battery characteristics and increase the battery efficiency.

Furthermore, as shown in FIG. 2, a connecting line 112 that is perpendicular to the finger 111 and electrically connected to the adjacent finger 111 can be provided between any two adjacent fingers 111. This connecting line 112 can be integrally formed with the adjacent finger 111, i.e., it can be manufactured simultaneously during the manufacturing of the finger 111. This connecting line 112 can be located near the intersection of the finger 111 and the electrical connecting member 12. By setting the connecting line 112, after the finger 111 is broken, the current can be collected through the connecting line 112 and transmitted to the adjacent finger, so as to achieve the purpose of current collection and ensure the photoelectric conversion efficiency of the cell. The number of connecting lines 112 can be set as needed. The width of the connecting line 112 is generally consistent with that of the finger.

In a preferred embodiment, between the fingers 111 at the edge of the cell and the adjacent fingers 111, there are provided connecting lines 112 that are electrically connected to the fingers 111 at the edge and the adjacent fingers 111, ensuring effective current collection in the edge region.

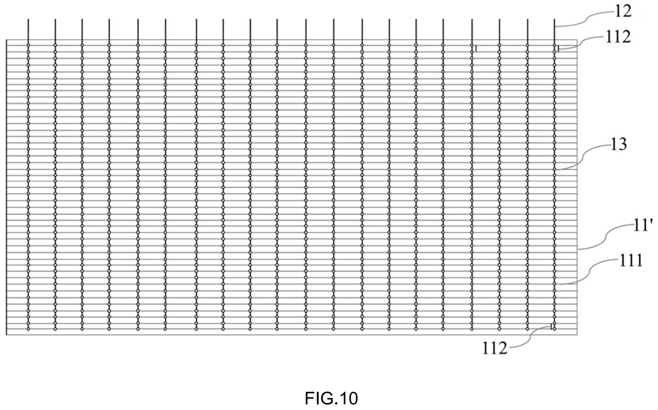

Furthermore, FIG. 9 illustrates a schematic diagram of the main process flow of a second method for manufacturing a photovoltaic module provided by embodiments of this disclosure. As shown in FIG. 9, the second method for manufacturing the photovoltaic module comprises the following steps:
Step S901: Connecting a plurality of cells 11 by means of electrical connecting members 12 to form a battery string;
The cells 11 comprise a first surface and a second surface, which are opposite to each other, and the first surface and the second surface of the cells 11 are each provided with a plurality of fingers and no busbar;
Step S902: Performing quality test on the battery string and manufacturing a photovoltaic module 20 using a qualified battery string;
Step S901 includes connecting each current cell 11' to a preceding cell 11" already existing in the battery string through the following steps S9011 and S9012 (not shown):
   Step S9011: Fixing and electrically connecting simultaneously a portion of the electrical connecting members 12 to the fingers formed on the first surface of the laid current cell 11', wherein the formation of the fingers on the first surface of the current cell 11' and the electrical connection to the plurality of electrical connecting members 12 are completed simultaneously;
      The structure obtained by the above step S9011 is shown in FIG. 10.
   Step S9012: Fixing and electrically connecting simultaneously another portion of the plurality of electrical connecting members 12 to the fingers formed on the second surface of the preceding cell 11" corresponding to the current cell 11', wherein the formation of the fingers on the second surface of the preceding cell 11" and the electrical connection to a plurality of the electrical connecting members 12 are completed simultaneously.

As described above, the current cell 11' generally refers to the cell 11 currently in operation and about to be connected in series to the battery string structure. The preceding cell 11" is a cell 11 that is connected in series to the battery string structure prior to the current cell 11' and is adjacent to the current cell 11'.

The above busbar-free cell generally refers to the absence of busbars for soldering and their corresponding pads or solder points. The width of the finger 111 on the first and second surfaces of said busbar-free cell is generally 14 µm to 40 µm, effectively reducing the shading of the cell surface by the gridlines on the cell surface. In a preferred embodiment, the above busbar-free cell is a busbar-free heterojunction cell.

In a preferred embodiment, the current cell 11' and the preceding cell 11" are both busbar-free heterojunction cells, and the first surface and the second surface are the front side and the back side of the cell 11, respectively.

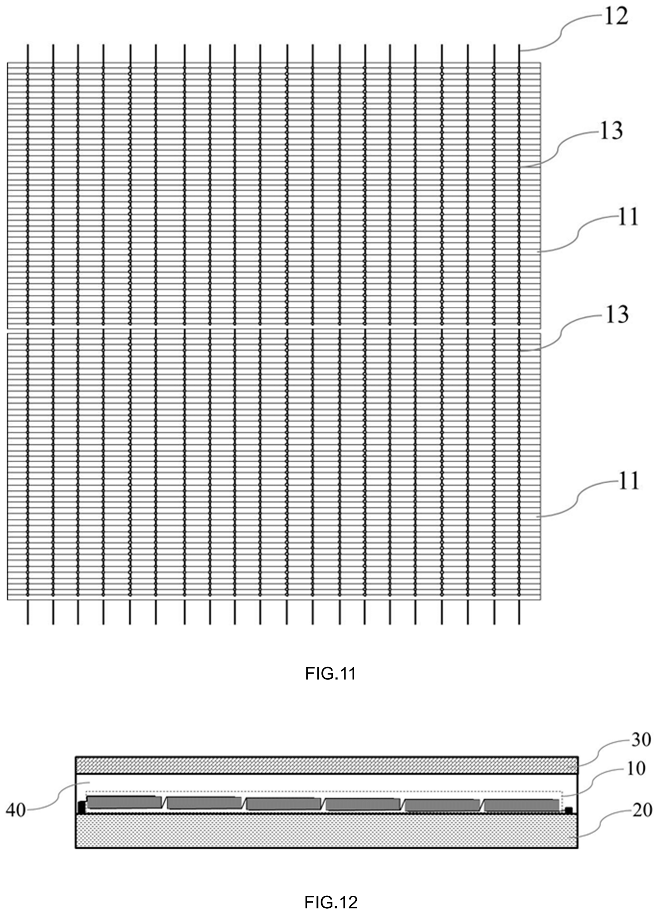

In the battery string obtained through the above process, the relative positional relationship between two adjacent busbar-free heterojunction cells can be shown in FIG. 11.

In addition, in the battery string formed in the above step S901, a plurality of electrical connecting members 12 are generally provided between each two adjacent cells 11 to enhance the electrical conductivity of the photovoltaic module and the connection strength between the cells.

The electrical connecting members 12 are typically tin-coated copper wires.

Compared to the existing methods of manufacturing photovoltaic modules using busbar-free cells, which only achieve series connection between busbar-free cells within a battery string during the lamination stage, the second method of manufacturing photovoltaic modules provided herein, same as the first manufacturing method, utilizes busbar-free cells to manufacture the battery string. When the fingers are formed simultaneously with the formation of electrical connection to the electrical connecting members, i.e. a reliable ohmic contact is formed between the electrical connecting members and the busbar-free cells before lamination, perform quality test on the battery string directly to select qualified battery strings for manufacturing into photovoltaic modules. Furthermore, the battery string can be repaired before lamination, effectively improving the reliability and mass production yield rate of the photovoltaic modules.

Furthermore, step S9011 may further include: providing a protective member 13 at the intersection of the finger 111 and the electrical connecting member 12 on the first surface of the current cell 11'.

Step S9012 may further include: providing a protective member 13 at the intersection of the finger 111 on the second surface of the preceding cell 11" and the electrical connecting member 12.

Protective members 13 are provided at multiple intersections of the fingers 111 on each cell 11 and the plurality of electrical connecting members 12 to protect the electrical connection points between the cells 11 and the electrical connecting members 12 to which they are fixed, so that the lamination pressure applied during the subsequent lamination process of manufacturing photovoltaic modules will not damage the electrical connection points. In particular, even if busbar-free heterojunction cells are used to manufacture battery strings, series connections between the busbar-free heterojunction cells in the battery strings can be constructed before lamination. Perform quality test on the battery string directly to select qualified battery strings for manufacturing into photovoltaic modules. Furthermore, the battery string can be repaired before lamination, effectively improving the reliability and mass production yield rate of the photovoltaic modules.

Compared to the existing method of manufacturing photovoltaic modules using busbar-free cells, which achieves series connection between busbar-free cells within the battery string by virtue of lamination temperature during the lamination stage, the second method of manufacturing photovoltaic modules provided by this disclosure can also complete the series connection between the respective busbar-free cells in the battery string before lamination, so that the way to achieve series connection is no longer restricted by conditions such as lamination temperature, and the electrical connecting members for connecting the busbar-free cells in series can be made of materials with relatively high temperature (e.g., materials having a temperature higher than the lamination temperature). That is to say, the solution provided by the embodiments of this disclosure can choose the electrical connecting members having a melting point temperature higher than the lamination temperature, ensuring high-temperature resistance and reliability of the photovoltaic module and enabling it to adapt to high-temperature environments.

Moreover, compared to the existing process of manufacturing photovoltaic modules with busbar-free heterogeneous cell, which uses a carrier film to fix and connect the solder ribbons in series in the busbar-free cells, the second method of manufacturing the photovoltaic module provided by the embodiments of this disclosure can also achieve the purpose of fixing the electrical connecting members through the combined action of the electrical connection between the cells and the electrical connecting members and the protective member, without the need for setting a carrier film that covers the electrical connecting members. This prevents light shading by the carrier film and thereby improves the photoelectric conversion performance of the battery string and the manufactured photovoltaic modules.

Furthermore, different from the first manufacturing method described above, the second manufacturing method comprises that the process of curing the low-temperature metal paste to form the fingers and the process of forming stable electrical connection between the fingers and the electrical connecting members are simultaneously completed by single-step curing, which ensures high mass production yield rate for photovoltaic modules and effectively simplifies the process of manufacturing photovoltaic modules.

The first cell in the above battery string generally refers to the first cell laid on the string soldering platform during the battery string manufacturing process.

If the current cell 11' is the first cell of the battery string, after completing the above step S9011 with the first cell as the current cell, steps S9011 and S9012 are then executed directly with the second cell as the current cell.

Specifically, the implementation of step S9011 may include: printing a metal paste for forming the fingers on the first surface of the current cell 11'; bonding a portion of the plurality of electrical connecting members 12 to the metal paste according to a predetermined position, and curing the metal paste. This process utilizes the adhesive properties of the metal paste to fix the electrical connecting members 12 without the need for setting adhesive members to fix the electrical connecting members 12, which provides a basis for subsequent simultaneous curing to form the fingers and form the electrical connection between the fingers and the electrical connecting members.

Specifically, the implementation of step S9012 may include: printing a metal paste for forming the fingers on the second surface of the preceding cell 11" corresponding to the current cell 11'; bonding another portion of the plurality of electrical connecting members 12 to the metal paste according to a predetermined position, and curing the metal paste. Specifically, the metal paste for forming fingers is printed on the second surface of the preceding cell 11" only when the electrical connecting members 12 are to be connected to the second surface of the preceding cell 11", to prevent damage to the metal paste before it is bonded to the electrical connecting members 12.

Both the step of curing the metal paste included in the implementation of the above step S9011 and the step of curing the metal paste included in the implementation of the above step S9012 can cure the metal paste in two ways.

Furthermore, to achieve the arrangement of protective members 13 at the intersections of the fingers 111 and the electrical connecting members 12, the above step S9011 may further include: spraying or coating an adhesive on the multiple intersections of the metal paste printed on the first surface of the current cell 11' and the plurality of electrical connecting members 12; and simultaneously curing the adhesive during the above process of curing the metal paste, respectively.

Additionally, the above step S9012 may further include: spraying or coating adhesive on the multiple intersections of the metal paste printed on the second surface of the preceding cell 11" and the plurality of electrical connecting members 12; and simultaneously curing the adhesive during the above process of curing the metal paste, respectively.

The protective member 13 is formed by curing the adhesive, which not only protects the electrical connection between the fingers and the electrical connecting members, but also simplifies the manufacturing process of the entire cell and battery string and makes it easy to operate. The embodiments of this disclosure provide two methods for curing the metal paste and adhesive.

The first way for curing the metal paste and adhesive includes thermally curing the metal paste at 150-200 °C and forming the adhesive of the protective member 13 simultaneously to from stable fingers and the electrical connection.

The second way for curing the metal paste and adhesive includes first curing the adhesive using a light-curing method and then thermally curing the metal paste. This second way for curing the metal paste and adhesive includes first curing the adhesive and then fixing the electrical connecting members through said cured adhesive to prevent the electrical connecting members from being displaced, thereby preventing the electrical connecting members from causing the metal paste to be displaced, and can further enhance the stability of the grid structure formed by the electrical connecting members and the metal paste.

The printing platform used for printing the metal paste is provided with a gap corresponding to the electrical connecting member 12. In the process of printing the metal paste, the electrical connecting member 12 located on the other main surface of the cell is placed within the gap to achieve an object of stabilizing the heterojunction cell during the metal paste printing process, preventing damage to the heterojunction cell during the printing process.

Furthermore, the above metal paste for forming the finger 111 can be different from the metal paste in contact with the electrical connecting member 12 (for example, the metal paste for forming the finger is a conventional metal paste for manufacturing fingers, while the metal paste in contact with the electrical connecting member 12 is a low-temperature silver paste) and can be printed in batches. The metal paste for the fingers can be printed and dried first, and then the metal paste in contact with the electrical connecting member 12 can be partially printed to perform the above operations. In another embodiment, the metal paste for forming the finger can be the same as the metal paste in contact with the electrical connecting member 12. For example, both the metal paste for forming the finger and the metal paste in contact with the electrical connecting member 12 can be low-temperature silver paste.

Furthermore, the protective member 13 can be cured simultaneously with the metal paste, or it can be cured by light first to initially fix the cell 11 and the electrical connecting member 12.

Furthermore, the electrical connecting member 12 used in each embodiment of the second method for manufacturing photovoltaic modules described above generally has a melting point of no less than 140 °C. This allows the electrical connecting member 12 to be electrically connected to the fingers 111 of the cell 11 through a relatively reliable soldering method (the relatively reliable soldering method generally has a relatively high soldering temperature), while preventing damage to the electrical connecting member 12 from lamination temperature, thereby ensuring stable electrical conductivity of the battery string.

Furthermore, the protective member 13 used in each embodiment of the second method for manufacturing photovoltaic modules described above generally has a temperature resistance of no less than 150 °C. The selection of the protective member 13 with a temperature resistance of no less than 150 °C can still achieve the protection effect during the photovoltaic module lamination stage, preventing the solder points of the electrical connecting member 12 (i.e., the intersections between the electrical connecting member 12 and the finger 111) from being broken due to lamination pressure.

Furthermore, as shown in FIG.10, a connecting line 112 that is perpendicular to the fingers 111 and electrically connected to the adjacent fingers 111 can be provided between any two adjacent fingers 111. The connecting line 112 can be integrally formed with the adjacent fingers 111, that is, the connecting line 112 is manufactured simultaneously with the process of manufacturing fingers 111. The connecting line 112 can be located near the intersection of the fingers 111 and the electrical connecting members 12. By providing the connecting line 112, after the fingers 111 are broken, current can be collected through the connecting line 112 and the collected current can be transmitted to the adjacent fingers to achieve the purpose of collecting current and ensure the photoelectric conversion efficiency of the cell. The number of connecting lines 112 can be set as required. The width of the connecting line 112 is generally consistent with that of the fingers.

In a preferred embodiment, between the fingers 111 at the edge of the cell and the adjacent fingers 111, there are provided connecting lines 112 that are electrically connected to the fingers 111 at the edge and the adjacent fingers 111, ensuring effective current collection in the edge region.

In summary, the core steps of the second method of manufacturing photovoltaic modules mainly include: printing a low-temperature metal paste with adhesive properties on one major surface of the cell; placing the electrical connecting member (such as tin-coated copper wires) on the major surface coated with the low-temperature metal paste; and then thermally curing to simultaneously form an effective ohmic connection (i.e., electrical connection) between the fingers and the fingers and the electrical connecting member, thereby enhancing the adhesion between the electrical connecting member and the fingers and between the fingers and the cell; and subsequently conducting the adhesive dispensing at the intersections of the electrical connecting member and the fingers to strengthen the connection between the electrical connecting member and the fingers.

In a preferred embodiment, the cell used in the above second method of manufacturing photovoltaic modules is a heterojunction cell.

In addition, in the above two manufacturing methods, there is a correlation between the number S of electrical connecting members connected to a main surface (front side or back side) of each cell (especially for heterojunction cells), the width of the electrical connecting member (if the cross-section of the electrical connecting member is circular, it is the radius of the electrical connecting member) r and the short-circuit current of the cell: r=a×I/S, where r represents the width of the electrical connecting member (if the cross-section of the electrical connecting member is circular, it is the radius of the electrical connecting member); a represents the power loss coefficient that the cell can accept, which is usually in a range of 0.15~0.33; S represents the number of electrical connecting members connected to a main surface (front side or back side) of each cell; wherein, if a and r are larger, the heterojunction cells are more likely to crack, and the number S of electrical connecting members can be increased to achieve the purpose of reducing the interface radius r of the electrical connecting members, thereby reducing the occurrence of cracking of the heterojunction cell.

It is worth noting that the steps of manufacturing photovoltaic modules using the qualified battery strings 10 in the above two manufacturing methods also include electrically connecting the multiple arranged battery strings via busbars. That is, the electrical connecting members connected to the front side or back side of the cells at the end of the battery strings are connected to the busbars by soldering or conductive adhesive, thereby forming a series and/or parallel connection between the battery strings. Whether the battery strings are connected in series or in parallel can be determined based on needs for manufacturing the photovoltaic module and is not limited herein.

In addition, the stacking and lamination process of the steps of manufacturing photovoltaic modules using the qualified battery strings 10 in the above two manufacturing methods can be implemented using the existing photovoltaic module stacking and lamination methods.

It is worth noting that the number of battery strings formed in the above process of manufacturing photovoltaic modules, as well as the battery array structure formed by the connection in series or in parallel of the battery strings via busbars, can be determined based on actual needs and are not limited herein.

Furthermore, the embodiments of this disclosure provide a photovoltaic module. FIG. 12 shows a cross-sectional schematic diagram of a photovoltaic module. As shown in FIG. 12, the photovoltaic module comprises: a battery string 10 arranged side by side, a cover plate 20, a back plate 30, and an encapsulation layer 40. The encapsulation layer 40 is used to encapsulate the battery string 10 arranged side by side between the cover plate 20 and the back plate 30.

As shown in FIG. 6 and FIG. 11, the battery string 10 comprised by the photovoltaic module provided in the embodiments of this disclosure may include a plurality of cells 11, a plurality of electrical connecting members 12 disposed between each pair of adjacent cells 11, and a plurality of protective members 13 corresponding to each cell 11. The plurality of electrical connecting members 12 provided between each pair of adjacent cells 11 connect the finger on the first surface of one adjacent cell 11 to the finger on the second surface of another adjacent cell 11 in series. The plurality of protective members 13 are provided at multiple intersections of the fingers of each cell 11 and the plurality of electrical connecting members 12.

Furthermore, as shown in FIG. 6, the above photovoltaic module further comprises: a plurality of adhesive members 14 provided between adjacent fingers on the first surface and second surface of the cell 11. The adhesive members 14 are used to fix the electrical connecting members 12. The adhesive members 14 may be formed by printing adhesive dots. The protective member 13 may be formed by spraying or coating the adhesive. The electrical connecting members 12 in the photovoltaic module are generally tin-coated copper wires.

Furthermore, in the photovoltaic module described above, a connecting line 112 that is perpendicular to and electrically connected to the adjacent fingers 111, may be provided between any two adjacent fingers 111. This connecting line 112 can be integrally formed with the adjacent fingers 111, i.e., it can be manufactured simultaneously during the manufacturing of the finger 111. This connecting line 112 can be located near the intersection of the finger 111 and the electrical connecting member 12. By setting the connecting line 112, after the finger 111 is broken, the current can be collected through the connecting line 112 and transmitted to the adjacent finger, so as to achieve the purpose of current collection and ensure the photoelectric conversion efficiency of the cell. The number of connecting lines 112 can be set as needed. The width of the connecting line 112 is generally consistent with that of the finger.

In a preferred embodiment, between the fingers 111 at the edge of the cell and the adjacent fingers 111, there are provided connecting lines 112 that are electrically connected to the fingers 111 at the edge and the adjacent fingers 111, ensuring effective current collection in the edge region.

In the photovoltaic module provided by the embodiments of this disclosure, due to the presence of the protective member 13, the purpose of protecting the intersection position between the electrical connecting members and the fingers can be achieved. At the same time, since the protective member 13 is only provided at the intersection position, it will not block other regions of the photovoltaic module. Compared to the existing solution of using a carrier film to fix and protect the electrical connecting members, it can effectively improve the photoelectric conversion performance of the photovoltaic module.

Furthermore, the embodiments of this disclosure also provide a power station, which may include the photovoltaic module provided by the embodiments mentioned above.

The above manufacturing methods will be described in detail using two specific examples.

### Example 1:

Taking the manufacturing of photovoltaic modules using half-cut busbar-free cells sliced from a busbar-free heterojunction cell as an example, the process of manufacturing the photovoltaic module may include the following steps:
Repeat steps A1 to C1 until the number of half-cut busbar-free cells reaches the required number, thereby obtaining a battery string structure:
Step A1: Print adhesive dots between the fingers on both main surfaces of the half-cut busbar-free cells sliced from the heterojunction cell, wherein the locations for printing the adhesive dots are illustrated in FIG. 2;
Step B1: Place pre-cut tin-coated copper wires onto the front side of the half-cut busbar-free cell according to the design layout, bonding the tin-coated copper wires to the adhesive dots and curing the adhesive dots. The tin-coated copper wires must extend sufficiently to facilitate bonding to the back side of the preceding half-cut busbar-free cell. After bonding to the half-cut busbar-free cell, the ends of the tin-coated copper wires should not protrude beyond the edge of the half-cut busbar-free cell. The relative positional relationship between the tin-coated copper wires and the printed adhesive dots is shown in FIG. 3;
Step C1: Invert an assembly of the half-cut busbar-free cell and the tin-coated copper wires, and arrange the inverted assembly of the half-cut busbar-free cell and the tin-coated copper wires, place the tin-coated copper wires of the inverted assembly protruding beyond the busbar-free cell onto adhesive dots on the back side of the preceding assembly, and curing the adhesive dots;
Step D1: Thermally weld the fingers of the busbar-free cells in the battery string structure to the tin-coated copper wires to alloy the tin-coated copper wires with the cell fingers, forming an ohmic contact favorable for current transmission and obtaining a battery string;
Step E1: Dispense adhesive dots via a dispenser at solder joints between the tin-coated copper wires and the fingers on the battery string, curing the adhesive dots to protect the solder joints between the tin-coated copper wires and the fingers, wherein the relative positional relationship of the adhesive dots for protecting the solder joints, the fingers, and the tin-coated copper wires is shown in FIG. 7 or FIG. 8;
Step F1: Perform EL test on the battery strings, subject the qualified battery to electrical injection or other effective measures, such as light injection, to improve battery efficiency;
Step G1: Manufacture the desired photovoltaic modules by arranging, stacking, and laminating the battery strings processed through Step F1.

### Example 2:

Taking the manufacturing of a half-cut heterojunction cell not yet provided with fingers as an example, the process for manufacturing a photovoltaic module comprises the following steps:
Step A2: Test and sort half-cut heterojunction cells not yet provided with fingers;
The half-cut heterojunction cells not yet provided with fingers are obtained by the existing heterojunction cell manufacturing processes up to TCO coating film.
Steps B2 to G2 are repeated until the number of half-cut heterojunction cell not yet provided with fingers reaches the desired number, thereby forming a battery string:
   Step B2: Print a low-temperature metal paste on the back side of the heterojunction cell not yet provided with fingers in a pattern corresponding to the arrangement of fingers;
   Step C2: Place the pre-cut tin-coated copper wires onto the back side of the heterojunction cell printed with the low-temperature metal paste, the number of tin-coated copper wires being 20; wherein the tin-coated copper wires are configured to extend a length sufficient for bonding to a back side of a preceding half-cut busbar-free cell, and wherein the ends of the tin-coated copper wires do not protrude beyond edges of the heterojunction cell to which the tin-coated copper wires adhere after adhesion to the printed low-temperature metal paste;
   Step D2: Dispense adhesive dots via a dispenser at the intersections where the tin-coated copper wires are bonded to the low-temperature metal paste;
   Step E2: Heat to approximately 200 °C to simultaneously cure the printed low-temperature metal paste and the adhesive dots on the back side of the heterojunction cell with adhesive dots by dispensing, thereby obtaining an assembly of the heterojunction cell having tin-coated copper wires and fingers on its back side, resulting in a structure as shown in FIG. 10;
   Step F2: Invert the assembly of the heterojunction cell with tin-coated copper wires and fingers on its backside, place the assembly of the heterojunction cell with its front side upward on a printing platform, and print a low-temperature metal paste on the front side of the assembly of the heterojunction cell;
   Step G2: Place the extending portions of the tin-coated copper wires from the front-side-printed assembly of the heterojunction cell onto the front side of a preceding front-side-printed assembly (hereinafter referred to as the "preceding assembly"); dispense adhesive dots at the intersections between the low-temperature metal paste printed on the front side of the preceding assembly and the tin-coated copper wires; and heat to cure both the low-temperature metal paste printed on the front side of the preceding assembly and the adhesive dots applied thereto.

In this embodiment, since the tin-coated copper wires are already fixed on the back side of the heterojunction cell assembly during the printing of the low-temperature metal paste on the front side of the heterojunction cell assembly, a printing platform provided with a gap that corresponds to the tin-coated copper wires of the heterojunction cell assembly is used, so that the heterojunction cell assembly remains stable on the printing platform to facilitate front-side printing of the low-temperature metal paste.

Step H2: Heat the battery string to approximately 150 °C and apply a reverse bias current of about 7A for about 10 minutes to perform an electrical injection operation on the battery string.

Step I2: Perform EL test on the battery string after the electrical injection operation; and arrange, stack, and laminate the battery strings that pass the EL test according to a designed circuit to manufacture a photovoltaic module.

Alternatively, Example 2 can be replaced by first printing the low-temperature metal paste and establishing the electrical connection of the electrical connecting members on the front side of the heterojunction cell not yet provided with fingers, and then connecting the front sides of the heterojunction cells in series. The implementation process is consistent with Example 2, except that the operations described above for the front side of the heterojunction cell are applied to the back side, and the operations for the back side are applied to the front side. Detailed description thereof is omitted here.

The foregoing description of the steps is provided merely to aid in understanding the methods, structures, and core ideas of this disclosure. Those skilled in the art may make various improvements and modifications to this disclosure without departing from its principles, and such improvements and modifications shall also fall within the scopes of protection of the claims of this disclosure.

## Claims

1. A method for manufacturing a photovoltaic module, comprising:
step a1, fixing a plurality of cells (11) by means of electrical connecting members (12) to form a battery string structure; wherein
the cells (11) comprise a first surface and a second surface which are opposite to each other, and the first surface and the second surface of the cells (11) are each provided with a plurality of fingers and no busbar;
step b1, constructing an electrical connection between the cells (11) and the electrical connecting members (12) in the battery string structure to form a battery string (10);
step c1, performing quality test on the battery string (10), and manufacturing a photovoltaic module by using a qualified battery string;
the step a1 includes fixing each current cell (11') to a preceding cell (11") already existing in the battery string structure through the following steps:
step a11, fixing a portion of the electrical connecting members (12) to the finger on the first surface of the current cell (11'); and
step a12, fixing another portion of the electrical connecting members (12) to the finger on the second surface of the preceding cell (11").

2. The method according to claim 1, wherein, in the step a1, adhesive members (14) are provided on the first surface of the current cell (11') and the second surface of the preceding cell (11"), and the adhesive members (14) are located between adjacent fingers;
the electrical connecting members (12) are fixed to the fingers on the first surface of the current cell (11') and the fingers on the second surface of the preceding cell (11") by being bonded to the adhesive members (14).

3. The method according to claim 1, wherein the step b1 comprises: constructing the electrical connection between the cells (11) and a plurality of electrical connecting members (12) fixed thereto in the battery string structure by soldering.

4. The method according to claim 1, wherein the step b1, after the electrical connection is formed between the cells (11) and the electrical connecting members (12), further comprises:
providing a protective member (13) at an intersection of the fingers of the cells (11) and the electrical connecting members (12).

5. The method according to claim 4, wherein an adhesive is sprayed or coated at the intersection of the fingers of the cells (11) and the electrical connecting members (12), wherein the protective member (13) formed by spraying or coating the adhesive at least partially encapsulates a region on the intersection of the electrical connecting members (12).

6. The method according to claim 1, wherein a melting point of the electrical connecting members (12) is not less than 140 °C.

7. The method according to claim 4 or 5, wherein a temperature resistance of the protective member (13) is not less than 160 °C.

8. The method according to claim 2, wherein adhesive dots are printed as the adhesive member (14) on the first surface and the second surface of the current cell (11').

9. The method according to claim 1, wherein the electrical connecting members (12) are tin-coated copper wires.

10. A method for manufacturing a photovoltaic module, comprising:
step a2, connecting a plurality of cells (11) by means of electrical connecting members (12) to form a battery string; wherein
the cells (11) comprise a first surface and a second surface which are opposite to each other, wherein the first surface and the second surface of the cells (11) are each provided with a plurality of fingers and no busbar;
step b2, performing quality test on the battery string, and manufacturing a photovoltaic module (20) by using a qualified battery string;
step a2 comprises connecting each current cell (11') to a preceding cell (11") already existing in the battery string by the following steps:
step a21, fixing and electrically connecting simultaneously a portion of the electrical connecting members (12) to the fingers formed on the first surface of the laid current cell (11'), wherein the formation of the fingers on the first surface of the current cell (11') and the electrical connection to the electrical connecting members (12) are completed simultaneously; and
step a22: fixing and electrically connecting simultaneously another portion of the electrical connecting members (12) to the fingers formed on the second surface of the preceding cell (11") corresponding to the current cell (11'), wherein the formation of the fingers on the second surface of the preceding cell (11") and the electrical connection to a plurality of electrical connecting members (12) are completed simultaneously.

11. The method according to claim 10, wherein,
the step a21 comprises:
printing a metal paste for forming the fingers on the first surface of the current cell (11');
bonding a portion of the plurality of electrical connecting members (12) to the metal paste according to a predetermined position; and
curing the metal paste;
and/or
the step a22 comprises:
printing a metal paste for forming the fingers on the second surface of the preceding cell (11") corresponding to the current cell (11');
bonding another portion of the plurality of electrical connecting members (12) to the metal paste according to a predetermined position; and
curing the metal paste.

12. The method according to claim 11, wherein:
step a21 further comprises: providing a protective member (13) at an intersection of the fingers on the first surface of the current cell and the electrical connecting members (12);
and/or,
step a22 further comprises: providing a protective member (13) at the intersection of the fingers on the second surface of the preceding cell and the electrical connecting members (12).

13. The method according to claim 12, wherein:
step a21 comprises:
spraying or coating an adhesive at the multiple intersections of the metal paste printed on the first surface of the current cell (11') and the plurality of electrical connecting members (12); and
curing the adhesive and the metal paste ;
and/or,
step a22 comprises:
spraying or coating the adhesive at the multiple intersections of the metal paste printed on the second surface of the preceding cell (11") and the plurality of electrical connecting members (12); and
curing the adhesive and the metal paste .

14. The method according to claim 13, wherein curing the metal paste and the adhesive comprises:
thermally curing the metal paste and the adhesive at 150-200 °C simultaneously;
or
curing the adhesive by light curing and curing the metal paste by thermal curing.

15. The method according to claim 10, wherein a gap corresponding to the electrical connecting members (12) is provided on a printing platform for printing the metal paste.

16. The method according to claim 10, wherein the electrical connecting members (12) are tin-coated copper wires.

17. A photovoltaic module, comprising: battery strings (10) arranged side by side, a cover plate (20), a back plate (30), and an encapsulation layer (40), wherein,
the encapsulation layer (40) is used to encapsulate the battery strings (10) arranged side by side between the cover plate (20) and the back plate (30);
the battery string (10) comprises a plurality of cells (11), a plurality of electrical connecting members (12) arranged between each two adjacent cells (11), and a plurality of protective members (13) corresponding to each cell (11), wherein,
the plurality of electrical connecting members (12) arranged between each two adjacent cells (11) connect in series the fingers on the first surface of one adjacent cell (11) and the fingers on the second surface of another adjacent cell (11); and
the plurality of protective members (13) are arranged at multiple intersections between the fingers of each cell (11) and the plurality of electrical connecting members (12).

18. The photovoltaic module according to claim 17, further comprising: a plurality of adhesive members (14) provided between adjacent fingers on the first surface and the second surface of the cells (11), wherein the adhesive members (14) are used to bond the electrical connecting members 12.
